# EUROPEAN PATENT SPECIFICATION

(11) **EP 3 422 399 B1**
(45) Date of publication and mention of the grant of the patent: **31.07.2024**
(21) Application number: 17178592.6
(22) Date of filing: 29.06.2017
(51) Int. Cl.: H01L 23/24, H01L 23/26, H01L 23/29, H01L 23/00, H01L 25/07

(54) **METHOD FOR PRODUCING A DEVICE FOR PROTECTING A SEMICONDUCTOR MODULE AND SEMICONDUCTOR MODULE COMPRISING SAID DEVICE**
VERFAHREN ZUR HERSTELLUNG EINER VORRICHTUNG ZUM SCHUTZ EINES HALBLEITERMODULS UND HALBLEITERMODUL MIT DIESER VORRICHTUNG
PROCÉDÉ DE FABRICATION D'UN DISPOSITIF DE PROTECTION D'UN MODULE SEMI-CONDUCTEUR ET MODULE SEMI-CONDUCTEUR COMPORTANT CE DISPOSITIF

(43) Date of publication of application: 02.01.2019
(73) Proprietor: Infineon Technologies AG, 85579 Neubiberg (DE)
(72) Inventor: Uhlig, Johannes, 59494 Soest (DE); Mücke, Achim, 59597 Erwitte (DE)
(74) Representative: Westphal, Mussgnug & Partner, Patentanwälte mbB

(56) References cited:
- JP-B2- 3 456 257
- US-A1- 2009 084 602
- US-A1- 2013 011 998
- US-A1- 2015 001 700
- US-A1- 2017 162 461

## Description

### TECHNICAL FIELD

The instant disclosure relates to a device for protecting a semiconductor module, in particular a device for protecting a semiconductor module against corrosion, a method for producing the same and a semiconductor module.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted to the semiconductor substrate by soldering or sintering techniques.

Electrical lines or electrical connections are used to connect different semiconductor devices. Such electrical lines and electrical connections may include metal and/or semiconductor material. The housings of power semiconductor module arrangements are generally permeable to gases to a certain extent. Some gases such as sulfur containing gases, for example, may react with metallic components inside the housing. This leads to a chemical degradation of these components which may result in a failure of individual components and ultimately of the whole semiconductor arrangement.

Document US 2013/0011998 A1 discloses a sheet for forming a resin film for a chip, with which a semiconductor device is provided with a gettering function. The sheet is obtained without performing special treatment to a semiconductor wafer and the chip. The sheet has a release sheet, and a resin film-forming layer, which is formed on the releasing face of the release sheet, and the resin film-forming layer contains a binder polymer component, a curing component, and a gettering agent.

Document US 2009/0084602 A1 discloses an automotive electric/electronic package comprising an electronic component, a case for receiving the electronic component therein, and a lid covering an open top of the case. The case and the lid are joined together with a fluorochemical adhesive capable of chemically and/or physically adsorbing a corrosive gas. The package has highly reliable corrosion resistance in that the electronic component is protected from corrosion by corrosive acidic or basic gases such as sulfur compound and nitrogen oxide gases.

Document US 2017/0162461 A1 discloses a semiconductor device. The semiconductor device includes a first semiconductor component having a semiconductor substrate, and a barrier layer disposed at least on or at a portion of the first semiconductor component. The barrier layer includes a polymer material and an organic metal complexing agent covalently bound to the polymer material.

There is a need for a device that protects the semiconductor components against corrosion such that the overall lifetime of the power semiconductor module arrangement is increased.

### SUMMARY

A method for producing a device for protecting a power semiconductor module arrangement includes mixing a first material and a second material, wherein the first material is a liquid or viscous dielectric and wherein the second material is distributed within the first material and comprises a reactant, wherein the reactant is configured to chemically react with, trap, adsorb, or absorb corrosive gases. The method further includes filling the mixture into a casting mold, developing the mixture into a solid or semi-solid mat or plate, with the second material evenly distributed therein, removing the mat or plate from the casting mold, and inserting the solid or semi-solid mat or plate into a housing of a power semiconductor module arrangement. The solid or semi-solid mat or plate after inserting the solid or semi-solid mat or plate in the housing, only forms a non-permanent adhesive bond with any of the other components of the power semiconductor module arrangement.

A device for protecting a power semiconductor module arrangement which does not fall under the scope of the claims includes a first material, wherein the first material is a dielectric material, and a second material, wherein the second material is distributed within the first material and includes a reactant, wherein the reactant is configured to chemically react with, trap, adsorb, or absorb corrosive gases. The first material forms a flexible mat or a rigid plate with the second material distributed therein. The device is suitable to be inserted in a housing of the power semiconductor module arrangement. The device, after being inserted into the housing forms a non-permanent adhesive bond with the power semiconductor module arrangement

A power semiconductor module arrangement includes a semiconductor substrate comprising a dielectric insulation layer disposed between a first metallization layer and a second metallization layer, and arranged within a housing, at least one semiconductor body arranged on a top surface of the semiconductor substrate, a first protective layer arranged on the top surface of the semiconductor substrate, thereby covering the at least one semiconductor body, and a device for protecting the power semiconductor module arrangement. The device includes a first material, wherein the first material is a dielectric material, and a second material, wherein the second material is distributed within the first material and comprises a reactant, wherein the reactant is configured to chemically react with, trap, adsorb, or absorb corrosive gases. The first material forms a flexible mat or a rigid plate with the second material evenly distributed therein. The device only forms a non-permanent adhesive bond with any of the other components of the power semiconductor module arrangement.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a conventional power semiconductor module arrangement.
Figure 2 is a cross-sectional view of a power semiconductor module arrangement with a device for protecting the power semiconductor module arrangement.
Figure 3 is a cross-sectional view of a power semiconductor module arrangement before inserting the device for protecting the power semiconductor module arrangement.
Figure 4 is a cross-sectional view of another power semiconductor module arrangement before inserting a device for protecting the power semiconductor module arrangement.
Figure 5 schematically illustrates a top view of the power semiconductor module arrangement of Figure 2.
Figure 6 schematically illustrates a top view of a power semiconductor module arrangement similar to the arrangement of Figure 2.
Figure 7 schematically illustrates a top view of the power semiconductor module arrangement of Figure 4 with the device for protecting the power semiconductor module arrangement inserted into the housing.
Figure 8, including Figures 8A to 8D, schematically illustrates a method for producing a device for protecting a power semiconductor module arrangement.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

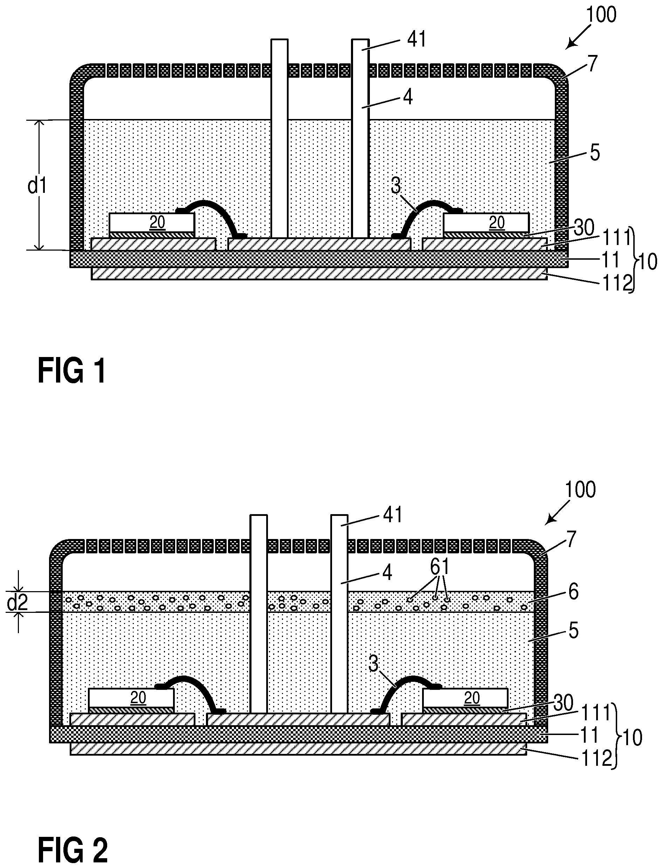

Referring to Figure 1, a cross-sectional view of a conventional power semiconductor module arrangement 100 is illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminium; an aluminium alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminium oxide; aluminium nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminium Bonding (DAB) substrate, or an Active Metal Brazing (AMB) substrate. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 7. In the example illustrated in Figure 1, the semiconductor substrate 10 forms a ground surface of the housing 7, while the housing 7 itself solely comprises sidewalls and a cover. This is, however, only an example. It is also possible that the housing 7 further comprises a ground surface and the semiconductor substrate 10 is arranged inside the housing 7. According to another example, the semiconductor substrate 10 may be mounted on a base plate (not illustrated). In some power semiconductor module arrangements 100, more than one semiconductor substrate 10 is arranged on a single base plate. The base plate may form a ground surface of the housing 7, for example.

One or more semiconductor bodies 20 may be arranged on the semiconductor substrate 10. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end, while a second end 41 of the terminal elements 4 protrudes out of the housing 7. The terminal elements 4 may be electrically contacted from the outside at their second end 41.

The semiconductor bodies 20 each may include a chip pad metallization, e.g., a source, drain, anode, cathode or gate metallization. A chip pad metallization generally provides a contact surface for electrically connecting the semiconductor body 20. The chip pad metallization may electrically contact a connection layer 30, a terminal element 4, or an electrical connection 3, for example. A chip pad metallization may consist of or include a metal such as aluminium, copper, gold or silver, for example. The electrical connections 3 and the terminal elements 4 may also consist of or include a metal such as copper, aluminium, gold, or silver, for example.

The above mentioned components, as well as other components of the semiconductor arrangement inside the housing 7, may corrode when they come into contact with corrosive gases. Corrosive gases may include, e.g., sulfur or sulfur-containing compounds. Corrosive gases in the surrounding area of the power semiconductor module arrangement 100 may penetrate into the inside of the housing 7. The housings 7 that are used for power semiconductor module arrangements 100 are usually not fully protected against protruding gases. Further, corrosive gases may enter the housing 7 when the housing 7 is opened or before the housing 7 is closed, for example. Inside the housing 7, the corrosive gases may form acids or solutions, for example, in combination with moisture that is present inside the housing 7. The corrosive gases or the resulting solutions may cause a corrosion of some or all of the components. During the corrosion process, the metallic constituents of the components may be oxidized to their respective sulfides. The sulfide formation may alter the electrical properties of the components or may result in the formation of new conductive connections and in short circuits within the power semiconductor module arrangement 100.

Examples for corrosive gases are hydrogen sulfide (H₂S), carbonyl sulfide (OCS), or gaseous sulfur (Ss). Generally, it is also possible that sulfur gets to the inside of the housing 7 as constituent of a solid material or liquid.

Components including one or more metals such as copper (e.g., first metallization layer 111, electrical connection 3, terminal element 4, connection layer 30, chip pad metallization), silver (e.g., first metallization layer 111, electrical connection 3, terminal element 4, connection layer 30, chip pad metallization), or lead (e.g. connection layer 30 including leaded solder), may be particularly sensitive to corrosion. Other metals such as aluminium, for example, may have a thin oxide layer covering their surface area, which may provide at least a certain amount of protection against corrosive gases.

The power semiconductor module arrangement 100 generally further includes a casting compound 5. The casting compound 5 may consist of or include a silicone gel or may be a rigid molding compound, for example. The casting compound 5 may at least partly fil the interior of the housing 7, thereby covering the components and electrical connections that are arranged on the semiconductor substrate 10. The terminal elements 4 may be partly embedded in the casting compound 5. At least their second ends 41, however, are not covered by the casting compound 5 and protrude from the casting compound 5 through the housing 7 to the outside of the housing 7. The casting compound 5 is configured to protect the components and electrical connections inside the power semiconductor module 100, in particular inside the housing 7, from certain environmental conditions and mechanical damage. However, corrosive gases are usually able to penetrate through the casting compound 5. The casting compound 5, therefore, is usually not able to protect the components and electrical connections from corrosive gases.

The casting compound 5 may form a first protective layer with a first thickness d1 in a vertical direction. The vertical direction is a direction that is essentially perpendicular to a top surface of the semiconductor module 10. The top surface of the semiconductor module 10 is a surface to which semiconductor bodies 20 are or may be mounted. The first protective layer 5 at least partly covers any components that are arranged on the top surface of the semiconductor substrate 10 as well as any exposed surfaces of the semiconductor substrate 10. The first thickness d1 may be between 1mm and 10mm, for example.

Referring to Figure 2, to additionally protect the components inside the housing 7 against corrosive gases, the power semiconductor module arrangement 100 further includes a second protective layer 6. The second protective layer 6 is arranged on a top surface of the first protective layer 5. The top surface of the first protective layer 5 is a surface opposite to its lower surface, wherein the lower surface covers the components and the semiconductor substrate 10. The second protective layer 6 is configured to seal at least a part of the inside of the housing 7. For example, the inside of the housing 7 may be divided in two areas, namely a first area in which the semiconductor substrate 10 and any components and electrical connections mounted to the semiconductor substrate 10 are arranged, and a second area which does not include any major components. For example, the first protective layer 5 may form an essential part of the first area. The terminal elements 4 may pass from the semiconductor substrate 10 through the first area (first protective layer 5) and through the second area to the outside of the housing 7. Without a second protective layer 6, corrosive gases may, for example, penetrate the second area and then reach the components of the semiconductor arrangement through the first area. The second protective layer 6 may be arranged between the first area and the second area, thereby protecting the first area and any components arranged in the first area against the corrosive gases. Corrosive gases, for example, may enter the second area of the inside of the housing 7 through the openings that allow the terminal elements 4 to pass through the housing 7. The corrosive gases, however, are prevented from entering the first area by the second protective layer 6.

The second protective layer 6 may have a second thickness d2 in the vertical direction. The second thickness d2 may be between 0.3mm and 10mm, for example. The second protective layer 6 includes a first material. The first material is a dielectric material. The second protective layer 6 further includes a reactant 61. The reactant 61 is configured to chemically react with the corrosive gases, or, in particular, with the sulfur or sulfur-containing compounds of the corrosive gases. Corrosive gas may also be trapped, adsorbed or absorbed by the reactant 61. By chemically reacting with the corrosive gas, the reactant 61 prevents the harmful substances from reaching the (metal) components inside the housing 7 and thereby protects the components against corrosion. The reactant 61 may be, for example, a powder of a second material which is distributed throughout the first material of the second protective layer 6. The second material may include a metallic material such as, e.g., Ag, Fe, Co, Ni, Cu, Sn, Pb, Mn or may include activated carbon, for example. These are, however, only examples. Any additional or alternative materials which react with the corrosive gases and which may, e.g., form a metal sulfide when exposed to corrosive gases, are also possible. The reactant 61 is essentially evenly distributed throughout the protective layer 6. The first material may consist of or include a non-reactive polymer such as a silicone gel or silicone rubber, for example. Other casting materials are also possible such as epoxy resin, for example.

If the second material is an electrically conductive material such as a metallic material, for example, the concentration of the second material in the second protective layer 6 may be such that the second protective layer 6 as a whole is still electrically insulating.

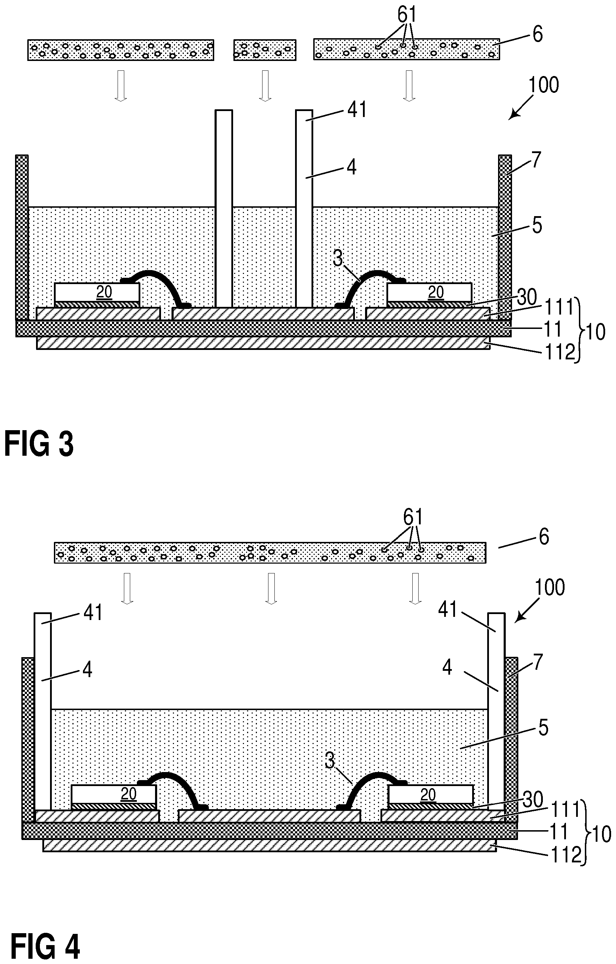

Referring to Figure 3, the second protective layer 6 is provided as a separate layer or mat. The protective layer 6 is produced separately and subsequently be inserted into the housing 7. The second protective layer 6 may include several parts, as is exemplarily illustrated in Figure 3. In other arrangements, however, the second protective layer 6 may only include one part, as is exemplarily illustrated in Figure 4. Generally, it depends on the geometry of the power semiconductor module arrangement 100 whether the second protective layer 6 includes only a single part or more than one part. In the example illustrated in Figure 3, the terminal elements 4 are arranged away from the sidewalls of the housing. For example, a distance between the terminal elements 4 and the sidewalls of the housing may be more than 0.1mm, more than 1mm or more than 10mm. In the example illustrated in Figure 4, the terminal elements 4 are arranged close to the sidewalls of the housing 7, which means that a distance between each terminal element 4 and at least one sidewall is essentially zero.

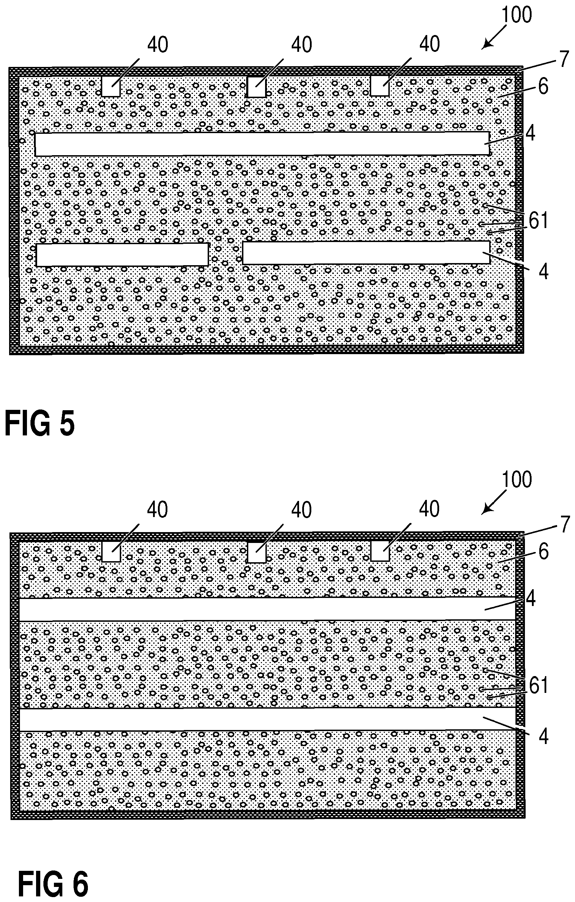

Figure 5 exemplarily illustrates a top view of the arrangement of Figure 3. The terminal elements 4 may be elongated in a first horizontal direction. The first horizontal direction is a direction that is essentially parallel to the top surface of the semiconductor substrate 10. The terminal elements 4 may be continuous elements extending from a first sidewall of the housing 7 to an opposite sidewall of the housing (e.g., top terminal element in Figure 5). The terminal elements 4, however, may also include one or more recesses (e.g., bottom terminal element 4 in Figure 5). As is illustrated in Figure 5, there may be a gap between the terminal elements 4 and all of the sidewalls of the housing 7. Referring to Figure 6, the gap between the terminal element 4 and at least one of the sidewalls is optional. In the example of Figure 6, each terminal element 4 adjoins one of the sidewalls with a first end and adjoins a second sidewall, opposite to the first sidewall, with a second end.

The power semiconductor module arrangement 100 may optionally further include auxiliary terminals 40. Such auxiliary terminals 40 may be arranged adjacent to one or more sidewalls of the housing 7. According to another example, there may be a gap between at least one of the auxiliary terminals 40 and the sidewalls of the housing 7. The auxiliary terminals 40 may also be configured to provide an electrical connection between the semiconductor substrate 10 and the outside of the housing 7.

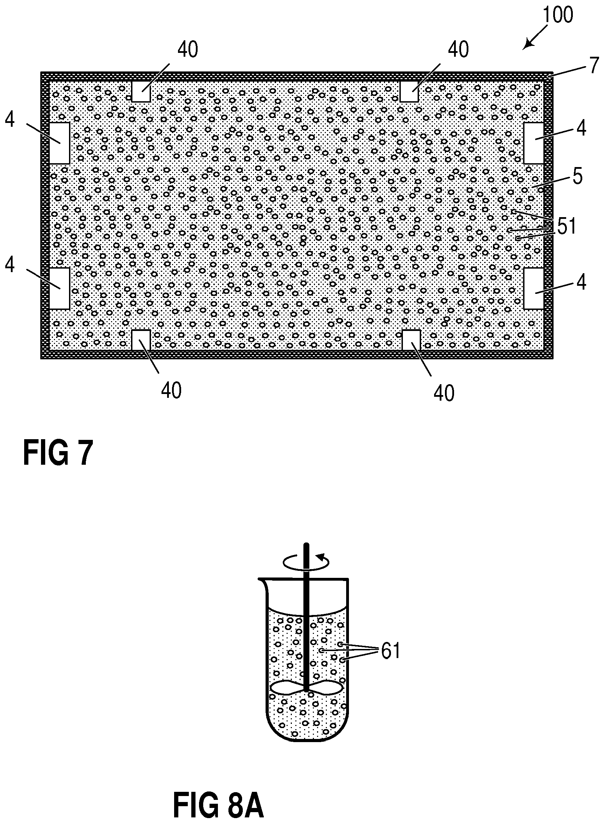

According to another example, as illustrated in Figure 7, the terminal elements 4 as well as the auxiliary terminals 40 are each arranged adjacent to at least one sidewall of the housing 7. Figure 7 exemplarily illustrates a top view of the power semiconductor module arrangement of Figure 4.

The geometries that are illustrated in Figures 3 to 7, however, are only examples to describe the invention in general terms. As can be seen from the Figures, the second protective layer 6 may be a continuous layer (see Figures 5 and 7) which includes openings and recesses through which the terminal elements 4 and auxiliary terminals 40 may pass. The dimensions of the second protective layer 6 depend on the size and the shape of the housing 7 and the size, shape and positions of the terminal elements 4 and/or the auxiliary terminals 40.

Ideally, there are no gaps or spaces between the second protective layer 6 and the sidewalls of the housing 7 as well as between the second protective layer and any other components (e.g., terminal elements 4 or auxiliary terminals 40) which extend through the second protective layer 6.

The protective layer 6 may be produced as a flexible mat. The flexible mat may be produced separately and may be arranged on the top surface of the first protective layer 5. It is, however, generally also possible that the second protective layer 6 is produced as a rigid plate instead of a flexible mat. The hardness of plastics and rubbers is generally defined as a material's resistance to permanent indentation. The hardness of plastics and rubbers is often measured by the so-called durometer hardness method, also known as shore hardness method. There are several scales of durometer, used for materials with different properties. The most common scales, using slightly different measurement systems, are the ASTM D2240 type A and type D scales. The A scale is for softer plastics while the D scale is for harder plastics. The second protective layer 6 may have a hardness in the range of Shore A x-y, for example. A layer with a hardness within the given range is not very sticking and, therefore, rather easy to handle. Other ranges of hardness, however, are also possible.

According to the claimed invention, the second protective layer 6 is produced by a process of casting into a mold. The materials forming the second protective layer 6, in particular the first material, are originally in a liquid or viscous form. A mixture is produced by mixing the first material and the second material. The mixture is then filled into a casting mold. After filling the mixture into the casting mold, the mixture is developed (processed) into a solid or semi-solid mat or plate with the second material evenly distributed therein. The casting mold may have a simple rectangular or quadratic form, for example. The resulting mat or plate, therefore, may also have a rectangular or quadratic form. Recesses for the terminal elements 4 or auxiliary terminals 40 may be cut out in a further step to adapt the form of the mat or plate to the geometry of the power semiconductor module arrangement 100. For example, an extrusion method may be used to shape the mat or plate. Extrusion methods are generally used to create objects of a fixed cross-sectional profile. A material (e.g., the solid or semi-solid mat or plate) is pushed through a die or press mold of the desired cross-section. In this way, very complex cross-sections of the mat or plate may be created. It is, however, also possible that the casting mold includes respective recesses such that the mat or plate is casted or molded in the desired shape without the need for a further cutting step.

The mat or plate is subsequently removed from the casting mold. For example, the mat or plate may be produced by a supplier. The manufacturer of the power semiconductor module arrangement 100 may buy the finished mat or plate and inserts the mat or plate into a power semiconductor module arrangement during the mounting process. The manufacturer, however, does not need to perform a molding step and/or a curing or hardening process when assembling the power semiconductor module arrangement 100. By simply arranging the prefabricated mat or plate in the power semiconductor module arrangement 100, the mat or plate does not have a substance-to-substance bond with any of the other components of the power semiconductor module arrangement 100. In other words, it would be generally possible to remove the mat or plate from the power semiconductor module arrangement 100, without destroying any of the other components. For example, the mat or plate does not have a substance-to-substance bond with the sidewalls of the housing. The mat or plate may have a certain adhesive strength and may adhere to the sidewalls to a certain degree. However, this is not a permanent bond. The same applies to the bond between the mat or plate and the first protection layer 5.

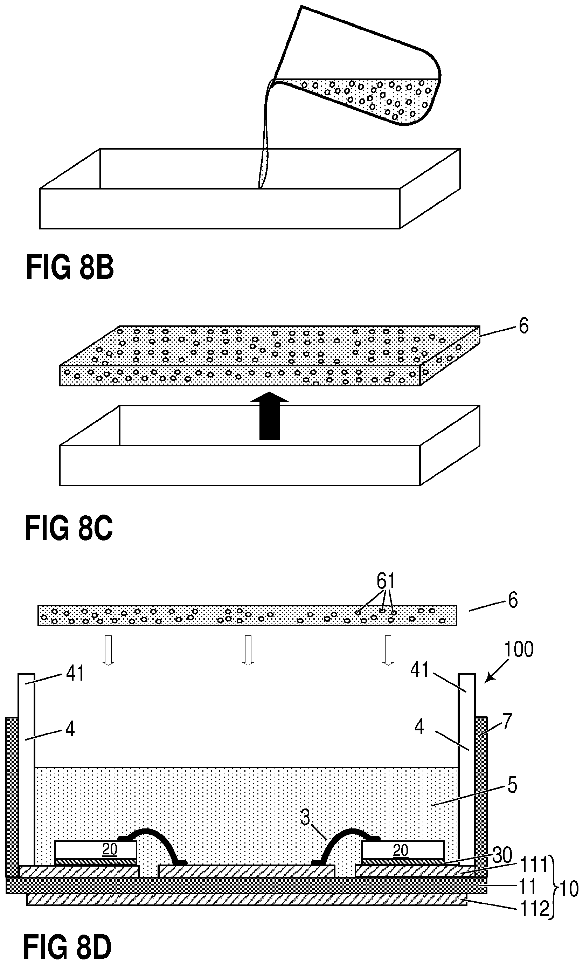

The method described above is schematically illustrated in Figure 8, wherein Figure 8A illustrates the step of mixing the first material and the second material. Figure 8B illustrates the step of filling the mixture into the casting mold. Referring to Figure 8C, the mat or plate 6 is removed from the casting mold. In a further step, as is illustrated in Figure 8D, the prefabricated mat or plate 6 is inserted in the housing 7 of a power semiconductor module arrangement 100, as has been described above.

## Claims

1. A method for producing a device for protecting a power semiconductor module arrangement (100), the method comprising:
mixing a first material and a second material, wherein the first material is a liquid or viscous dielectric material and wherein the second material is distributed within the first material and comprises a reactant (61), wherein the reactant (61) is configured to chemically react with, trap, adsorb, or absorb corrosive gases;
filling the mixture into a casting mold;
developing the mixture into a solid or semi-solid mat or plate (6), with the second material evenly distributed therein;
removing the mat or plate (6) from the casting mold; and
inserting the solid or semi-solid mat or plate (6) into a housing (7) of a power semiconductor module arrangement (100),
wherein the solid or semi-solid mat or plate (6), after inserting the mat or plate (6) into the housing (7), only forms a non-permanent adhesive bond with any of the other components of the power
semiconductor module arrangement (100).

2. The method of claim 1, wherein the first material comprises at least one of
a non-reactive polymer;
a casting materials; and
an epoxy resin.

3. The method of claim 2, wherein the non-reactive polymer comprises silicone gel or silicone rubber.

4. The method of any of claims 1 to 3, wherein the second material includes one of a metallic material and an activated carbon.

5. The method of claim 4, wherein the metallic material comprises at least one of Ag, Fe, Co, Ni, Cu, Sn, Pb, and Mn.

6. The method of any of the preceding claims, wherein the mat or plate (6) has a thickness of between 0.3mm and 10mm.

7. The method of any of claims 1 to 6, wherein
the power semiconductor module arrangement (100) comprises a semiconductor substrate (10) comprising a dielectric insulation layer (11) disposed between a first metallization layer (111) and a second metallization layer (112), and arranged within the housing (7), at least one semiconductor body (20) arranged on a top surface of the semiconductor substrate (10), and a first protective layer (5) arranged on the top surface of the semiconductor substrate (10), thereby covering the at least one semiconductor body (20), and
the mat or plate (6) is arranged on a top surface of the first protective layer (5), wherein the top surface of the first protective layer (5) is a surface facing away from the semiconductor substrate (10) and the at least one semiconductor body (20).

8. The method of claim 7,
wherein the inside of the housing (7) comprises a first area and a second area; and
wherein the mat or plate (6) is arranged between the first area and the second area in order to protect any components that are arranged in the first area from corrosive gases.

9. The method of any of the preceding claims, further comprising:
pulling the mat or plate (6) through a die, resulting in a desired cross-section of the mat or plate (6).

10. A power semiconductor module arrangement (100) comprising:
a semiconductor substrate (10) comprising a dielectric insulation layer (11) disposed between a first metallization layer (111) and a second metallization layer (112), and arranged within a housing (7);
at least one semiconductor body (20) arranged on a top surface of the semiconductor substrate (10);
a first protective layer (5) arranged on the top surface of the semiconductor substrate (10), thereby covering the at least one semiconductor body (20); and
a device (6) for protecting the power semiconductor module arrangement (100), the device (6) comprising a first material, wherein the first material is a dielectric material; and a second material, wherein the second material is distributed within the first material
and comprises a reactant (61), wherein the reactant (61) is configured to
chemically react with, trap, adsorb, or absorb corrosive gases; wherein the first material forms a flexible mat or a rigid plate with the second material evenly distributed therein, and wherein the device (6) only forms a non-permanent adhesive bond with any of the other components of the power
semiconductor module arrangement (100).

## Patentansprüche

1. Verfahren zum Herstellen einer Vorrichtung zum Schützen einer Leistungshalbleitermodulanordnung (100), wobei das Verfahren umfasst:
Mischen eines ersten Materials und eines zweiten Materials, wobei das erste Material ein flüssiges oder viskoses dielektrisches Material ist, und wobei das zweite Material innerhalb des ersten Materials verteilt ist und einen Reaktanten (61) umfasst, wobei der Reaktant (61) ausgestaltet ist, um chemisch mit korrosiven Gasen zu reagieren, diese einzufangen, zu adsorbieren oder zu absorbieren;
Füllen der Mischung in ein Gießformwerkzeug;
Entwickeln der Mischung zu einer festen oder halbfesten Matte oder Platte (6), wobei das zweite Material gleichförmig darin verteilt ist;
Entfernen der Matte oder Platte (6) aus dem Gießformwerkzeug; und
Einsetzen der festen oder halbfesten Matte oder Platte (6) in ein Gehäuse (7) einer Leistungshalbleitermodulanordnung (100),
wobei die feste oder halbfeste Matte oder Platte (6) nach dem Einsetzen der Matte oder Platte (6) in das Gehäuse (7) nur eine nicht-permanente Klebebindung mit jedweden der anderen Komponenten der Leistungshalbleitermodulanordnung (100) bildet.

2. Verfahren nach Anspruch 1, wobei das erste Material mindestens eines der folgenden umfasst:
ein nicht-reaktives Polymer;
Gießmaterial(ien); und
ein Epoxyharz.

3. Verfahren nach Anspruch 2, wobei das nicht-reaktive Polymer Silikongel oder Silikonkautschuk umfasst.

4. Verfahren nach einem der Ansprüche 1 bis 3, wobei das zweite Material eines von einem metallischen Material und einer Aktivkohle einschließt.

5. Verfahren nach Anspruch 4, wobei das metallische Material mindestens eines von Ag, Fe, Co, Ni, Cu, Sn, Pb und Mn umfasst.

6. Verfahren nach einem der vorhergehenden Ansprüche, wobei die Matte oder Platte (6) eine Dicke zwischen 0,3 mm und 10 mm aufweist.

7. Verfahren nach einem der Ansprüche 1 bis 6, wobei:
die Leistungshalbleitermodulanordnung (100) ein Halbleitersubstrat (10), umfassend eine dielektrische Isolierschicht (11), die zwischen einer ersten Metallisierungsschicht (111) und einer zweiten Metallisierungsschicht (112) angeordnet ist und innerhalb des Gehäuses (7) vorgesehen ist, mindestens einen Halbleiterkörper (20), der auf einer oberen Oberfläche des Halbleitersubstrats (10) vorgesehen ist, und eine erste Schutzschicht (5) umfasst, die auf der oberen Oberfläche des Halbleitersubstrats (10) vorgesehen ist, wodurch der mindestens eine Halbleiterkörper (20) bedeckt wird, und
die Matte oder Platte (6) auf einer oberen Oberfläche der ersten Schutzschicht (5) vorgesehen ist, wobei die obere Oberfläche der ersten Schutzschicht (5) eine Oberfläche ist, die von dem Halbleitersubstrat (10) und dem mindestens einen Halbleiterkörper (20) weg weist.

8. Verfahren nach Anspruch 7,
wobei die Innenseite des Gehäuses (7) einen ersten Bereich und einen zweiten Bereich umfasst; und
wobei die Matte oder Platte (6) zwischen dem ersten Bereich und dem zweiten Bereich vorgesehen ist, um jedwede Komponenten, die in dem ersten Bereich vorgesehen sind, vor korrosiven Gasen zu schützen.

9. Verfahren nach einem der vorhergehenden Ansprüche, des Weiteren umfassend:
Ziehen der Matte oder Platte (6) durch eine Düse, was zu einem gewünschten Querschnitt der Matte oder Platte (6) führt.

10. Leistungshalbleitermodulanordnung (100), umfassend:
ein Halbleitersubstrat (10), umfassend eine dielektrische Isolierschicht (11), die zwischen einer ersten Metallisierungsschicht (111) und einer zweiten Metallisierungsschicht (112) angeordnet ist, und innerhalb eines Gehäuses (7) vorgesehen ist;
mindestens einen Halbleiterkörper (20), der auf einer oberen Oberfläche des Halbleitersubstrats (10) vorgesehen ist;
eine erste Schutzschicht (5), die auf der oberen Oberfläche des Halbleitersubstrats (10) vorgesehen ist, wodurch der mindestens eine Halbleiterkörper (20) bedeckt wird; und
eine Vorrichtung (6) zum Schützen der Leistungshalbleitermodulanordnung (100), wobei die Vorrichtung (6) umfasst:
ein erstes Material, wobei das erste Material ein dielektrisches Material ist; und
ein zweites Material, wobei das zweite Material innerhalb des ersten Materials verteilt ist und einen Reaktanten (61) umfasst, wobei der Reaktant (61) ausgestaltet ist, um chemisch mit korrosiven Gasen zu reagieren, diese einzufangen, zu adsorbieren oder zu absorbieren;
wobei das erste Material eine flexible Matte oder eine starre Platte bildet, worin das zweite Material gleichförmig verteilt ist, und
wobei die Vorrichtung (6) nur eine nicht-permanente Klebebindung mit jedweder der anderen Komponenten der Leistungshalbleitermodulanordnung (100) bildet.

## Revendications

1. Procédé de production d'un dispositif de protection d'un agencement (100) de module à semiconducteur de puissance, le procédé comprenant :
mélanger une première matière et une deuxième matière, dans lequel la première matière est une matière diélectrique liquide ou visqueuse et dans lequel la deuxième matière est répartie au sein de la première matière et comprend un réactif (61), dans lequel le réactif (61) est configuré pour réagir chimiquement sur, piéger, adsorber, ou absorber des gaz corrosifs ;
remplir un moule de coulée du mélange ;
développer le mélange en une nappe ou une plaque (6) solide ou semi-solide, la deuxième matière y étant également répartie ;
retirer la nappe ou la plaque (6) du moule de coulée ; et insérer la nappe ou la plaque (6) solide ou semi-solide dans un boîtier (7) d'un agencement (100) de module à semiconducteur de puissance,
dans lequel la nappe ou la plaque (6) solide ou semi-solide, après insertion de la nappe ou de la plaque (6) dans le boîtier (7), forme seulement une liaison adhésive non permanente avec l'un quelconque des autres composants de l'agencement (100) de module à semiconducteur de puissance.

2. Procédé suivant la revendication 1, dans lequel la première matière comprend au moins l'un de
un polymère non réactif ;
une matière de coulée ; et
une résine époxy.

3. Procédé suivant la revendication 2, dans lequel le polymère non réactif comprend du gel de silicone ou du caoutchouc de silicone.

4. Procédé suivant l'une quelconque des revendications 1 à 3, dans lequel la deuxième matière comprend l'un d'un matériau métallique et d'un charbon actif.

5. Procédé suivant la revendication 4, dans lequel la matière métallique comprend au moins l'un de Ag, Fe, Co, Ni, Sn, Pb et Mn.

6. Procédé suivant l'une quelconque des revendications précédentes, dans lequel la nappe ou la plaque (6) a une épaisseur entre 0,3 mm et 10 mm.

7. Procédé suivant l'une quelconque des revendications 1 à 6, dans lequel
l'agencement (100) de module à semiconducteur de puissance comprend un substrat (10) de semiconducteur comprenant une couche (11) diélectrique isolante disposée entre une première couche (111) de métallisation et une deuxième couche (112) de métallisation et, disposés dans le boîtier (7), au moins un corps (20) à semiconducteur, disposé sur une surface de sommet du substrat (10) de semiconducteur, et une première couche (5) de protection, disposée sur la surface de sommet du substrat (10) de semiconducteur, en recouvrant ainsi le au moins un corps (20) à semiconducteur, et
la nappe ou la plaque (6) est disposée sur une surface de sommet de la première couche (5) de protection, dans lequel la surface de sommet de la première couche (5) de protection est une surface faisant face en en étant loin du substrat (10) de semiconducteur et du au moins un corps (20) à semiconducteur.

8. Procédé suivant la revendication 7,
dans lequel l'intérieur du boîtier (7) comprend une première zone et une deuxième zone ; et
dans lequel la nappe ou la plaque (6) est disposée entre la première zone et la deuxième zone afin de protéger n'importe lesquels composants, qui sont disposés dans la première zone, des gaz corrosifs.

9. Procédé suivant l'une quelconque des revendications précédentes, comprenant en outre :
tirer la nappe ou la plaque (6) dans une puce, ce qui donne une section transversale souhaitée à la nappe ou à la plaque (6).

10. Agencement (100) de module à semiconducteur de puissance comprenant :
un substrat (10) de semiconducteur comprenant une couche (11) diélectrique isolante disposée entre une première couche (111) de métallisation et une deuxième couche (112) de métallisation et, disposés dans un boîtier (7) ;
au moins un corps (20) à semiconducteur disposé sur une surface de sommet du substrat (10) de semiconducteur ;
une première couche (5) de protection disposée sur la surface de sommet du substrat (10) de semiconducteur, en recouvrant ainsi le au moins un corps (20) à semiconducteur ; et
un dispositif (6) pour protéger l'agencement (100) de module à semiconducteur de puissance, le dispositif (6) comprenant
une première matière, la première matière étant une matière diélectrique ; et
une deuxième matière, la deuxième matière étant répartie au sein de la première matière
et comprenant un réactif (61), le réactif (61) étant configuré pour réagir chimiquement sur, piéger, adsorber, ou absorber des gaz corrosifs ;
dans lequel la première matière forme une nappe souple ou une plaque rigide en ayant la deuxième matière, qui y est répartie également, et
dans lequel le dispositif (6) forme seulement une liaison adhésive non permanente avec l'un quelconque des autres composants de l'agencement (100) de module à semiconducteur de puissance.
